# EUROPEAN PATENT SPECIFICATION

(11) **EP 4 195 891 B1**
(45) Date of publication and mention of the grant of the patent: **26.06.2024**
(21) Application number: 22199107.8
(22) Date of filing: 30.09.2022
(51) Int. Cl.: H05K 5/06

(54) **AN INVERTER BOARD CASING**
WECHSELRICHTERBORDGEHÄUSE
BOÎTIER DE CARTE D'ONDULEUR

(30) Priority: 07.12.2021 TR 202119242
(43) Date of publication of application: 14.06.2023
(73) Proprietor: Arçelik Anonim Sirketi, 34445 Istanbul (TR)
(72) Inventor: KOK, Muslum Sinan, 34445 Istanbul (TR); BATUR, Yasin, 34445 Istanbul (TR); GUNDUZ, Cihan, 34445 Istanbul (TR)

(56) References cited:
- CN-A- 108 307 596
- CN-U- 208 900 853
- TW-B- 201 230 573

## Description

The present invention relates to an inverter board casing which encloses the inverter board.

The motor driver boards of the compressors used in cooling or air conditioning devices are kept in a separate plastic casing outside the compressor shell.

In the state of the art, in order to prevent insects from entering the casings of the motor inverter boards and causing a short circuit on the circuit board, a coating process known in the art as "potting" is performed on the circuit board. In order for this process to be applied effectively, the first cover of the casing, which is formed by combining two covers, must be in the form of a pool. One of the limitations of the casing design is the prevention of water entry into the casing. Moreover, components extending out of the casing, such as cables, must not be blocked. In particular, the exit points of the cables extending out of the casing are the most likely points where water entry may occur. It is critical to prevent water from entering the casing through these points.

The state of the art United States Patent No. US5745343, a motor and inverter casing of which the dimensions are reduced by using waste heat.

The state of the art Japanese Patent Application No. JP2018182930 discloses an inverter and motor unit having a casing comprising fins which remove the heat generated by the switching member.

Another state of the art publication no. TW201230573 discloses a terminal box having an output terminal, a terminal plate and a cover for closing the opening of the case. An additional state of the art publication disclosing a casing comprising a cover and second cover, is the document CN108307596, Lite On Electronics Guangzhou, published on 20 July 2018.

The aim of the present invention is the realization of an inverter board casing wherein the exit of the components such as cables extending outside is not blocked and the water entry is prevented.

The inverter board casing realized in order to attain the aim of the present invention, explicated in the first claim and the respective claims thereof, comprises a first cover; a second cover which is mounted onto the first cover such that the circuit board and the cables remain therebetween; a first receptacle which is arranged on the base of the first cover and which receives the circuit board; a second receptacle which is adjacent to the first receptacle and wherein the cables extending from the circuit board are borne; a first wall where the second receptacle is adjacent to the first receptacle; a second wall which is disposed opposite to the first wall; and at least one slot-shaped bearing on each of the first and second walls, which extends in the vertical axis and which is inclined from top to bottom.

The bearings on each wall form a pair, and each pair of bearings provides the bearing and exit of only one cable from the inverter board casing. Since the bearings on the first wall are inclined from the first wall to the second wall, from top to bottom, and the bearings on the second wall are inclined outward from the second wall, from top to bottom, a natural barrier is formed against the water entry with the effect of gravity, and the cables placed in the bearings prevent the water from entering the inverter board casing as a support component to said barrier.

By means of the bearings on the second receptacle in the inverter board casing, the water entry is prevented, and by means of the second receptacle, a pocket, so to speak, is formed in this area where the cables are located, thus creating an effective sealing zone against water entry.

In an embodiment of the present invention, there are two first and second bearings parallel to each other. Thus, two cables are allowed to enter/exit the inverter board casing.

In an embodiment of the present invention, the inverter board casing comprises at least one support which extends upwards from the base of the second receptacle, which is in the form of a protrusion, which extends parallel to the first and second walls, and which supports from below the cables placed in the first and second bearings.

In another embodiment of the present invention, the first and second bearings are located in the same inclined direction. The central axis passing through the middle of the first and second bearings is on the same inclined direction, and thus the side walls of the slot-shaped bearings are also located in the same inclined direction.

In another embodiment of the present invention, in the inverter board casing, the upper short side of the second receptacle is inclined from top to bottom. Thus, the flow rate of the water flowing over the outer surface of the inverter board casing is reduced, and by means of the water path formed, the flowing water is transmitted to a further point from the second wall, thus minimizing the possibility of water entering through the second bearing on the second wall.

By means of the present invention, the exit of the components such as cables extending outside is not prevented, and elements such as insects, water, etc. are prevented from entering the inverter board casing from the outside and damaging the circuit board or connections.

An inverter board casing realized in order to attain the aim of the present invention is illustrated in the attached figures, where:
- Figure 1: - is the perspective view of an inverter board casing.
- Figure 2: - is the sideways view of the detail A in Figure 1.

The elements illustrated in the figures are numbered as follows:
1. Inverter board casing
2. First cover
3. Second cover
4. First receptacle
5. Second receptacle
6. First wall
7. Second wall
8. First bearing
9. Second bearing
10. Circuit board
11. Cable
12. Support

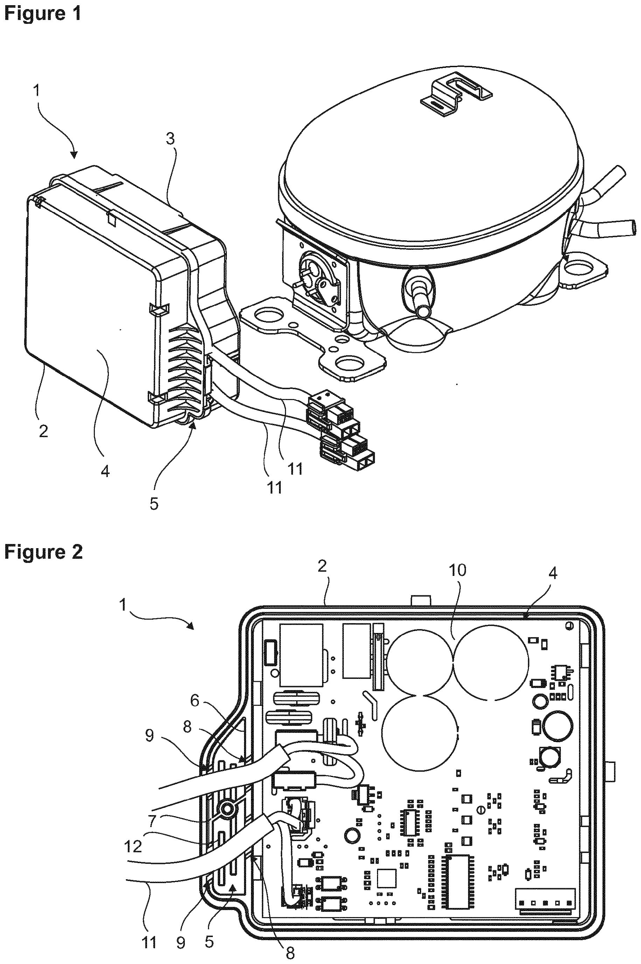

The inverter board casing (1) of the present invention comprises a first cover (2); a second cover (3) which is mounted onto the first cover (2) such that the circuit board (10) and the cables (11) remain therebetween; a first receptacle (4) which is arranged on the base of the first cover (2) and which receives the circuit board (10); a second receptacle (5) which is adjacent to the first receptacle (4) and wherein the cables (11) extending from the circuit board (10) are borne; a first wall (6) where the second receptacle (5) is adjacent to the first receptacle (4); a second wall (7) which is disposed opposite to the first wall (6); and at least one slot-shaped first bearing and at least one slot-shaped second bearing (8 and 9) on each of the first and second walls (6 and 7), which extend in the vertical axis and which are inclined from top to bottom (Figure 1 and Figure 2).

The first and second bearings (8 and 9) on each wall (6 and 7) form a pair, and each pair of first and second bearings (8 and 9) provides the bearing and exit of only one cable (11) from the inverter board casing (1). By means of inclination of the first and second bearings (8 and 9) from top to bottom, a natural barrier is formed against the water inlet with the effect of gravity, and the cables (11) placed in the first and second bearings (8 and 9) prevent the water from entering the inverter board casing (1) as a support component to said barrier. By means of the first and second bearings (8 and 9) on the second receptacle (5) in the inverter board casing (1), the water entry is prevented, and by means of the second receptacle (5), a pocket, so to speak, is formed in this area where the cables (11) are located, thus creating an effective sealing zone against water entry.

In an embodiment of the present invention, the inverter board casing (1) comprises at least one first bearing (8) on the first wall (6) and at least one second bearing (9) on the second wall (7).

In another embodiment of the present invention, the axes passing through the first and second bearings (8 and 9) are located in the same inclined direction. In this embodiment, the walls of the first and second bearings (8 and 9) are located in the same direction.

In an embodiment of the present invention, there are two first and second bearings (8 and 9) parallel to each other. Thus, two cables (11) are allowed to enter/exit the inverter board casing (1).

In an embodiment of the present invention, the inverter board casing (1) comprises at least one support (12) which extends upwards from the base of the second receptacle (5), which is in the form of a protrusion, which extends parallel to the first and second walls (6 and 7), and which supports from below the cables (11) placed in the first and second bearings (8 and 9). In the preferred embodiment of the present invention, there are two supports (12) which are parallel to each other.

In another embodiment of the present invention, in the inverter board casing (1), the upper short side of the second receptacle (5) is inclined from top to bottom. Thus, the flow rate of the water flowing over the outer surface of the inverter board casing (1) is reduced, and by means of the water path formed, the flowing water is transmitted to a further point from the second wall (7), thus minimizing the possibility of water entering through the second bearing (9) on the second wall (7).

By means of the present invention, elements such as insects, water, etc. are prevented from entering the inverter board casing (1) from the outside and damaging the circuit board (10) or cable (11) connections. Moreover, the exit of the components such as cables (11) extending out of the inverter board casing (1) is not prevented.

## Claims

1. An inverter board casing (1) **comprising** a first cover (2) and a second cover (3) which is mounted onto the first cover (2) such that a circuit board (10) and cables (11) remain therebetween, **characterized by** a first receptacle (4) which is arranged on the base of the first cover (2) and which receives the circuit board (10); a second receptacle (5) which is adjacent to the first receptacle (4) and wherein the cables (11) extending from the circuit board (10) are borne; a first wall (6) where the second receptacle (5) is adjacent to the first receptacle (4); a second wall (7) which is disposed opposite to the first wall (6); and at least one slot-shaped first bearing and at least one slot-shaped second bearing (8 and 9) on each of the first and second walls (6 and 7) and the first and second bearings (8 and 9) on each wall (6 and 7) form a pair wherein each pair of first and second bearings (8 and 9) provides a bearing and the exit of only one cable (11) from the inverter board casing (1), wherein the bearings (8 and 9) extend in the vertical axis and are inclined from top to bottom such that the bearings (8) on the first wall (6) are inclined from the first wall (6) to the second wall (7) and the bearings (9) on the second wall (7) are inclined outward from the second wall (7).

2. An inverter board casing (1) as in Claim 1, **characterized by** at least one first bearing (8) on the first wall (6) and at least one second bearing (9) on the second wall (7).

3. An inverter board casing (1) as in Claim 1 and 2, **characterized by** the first and second bearings (8 and 9) wherein the axes passing therethrough the center are located in the same inclined direction.

4. An inverter board casing (1) as in Claim 1, 2 and 3, **characterized by** two first and second bearings (8 and 9) which are parallel to each other.

5. An inverter board casing (1) as in any one of the above claims, **characterized by** at least one support (12) which extends upwards from the base of the second receptacle (5), which is in the form of a protrusion, which extends parallel to the first and second walls (6 and 7), and which supports from below the cables (11) placed in the first and second bearings (8 and 9).

6. An inverter board casing (1) as in any one of the above claims, **characterized by** the second receptacle (5) of which the upper short side is inclined from top to bottom.

## Patentansprüche

1. Ein Wechselrichterplatinengehäuse (1) **umfasst** eine erste Abdeckung (2) und eine zweite Abdeckung (3), die so auf der ersten Abdeckung (2) angebracht ist, dass eine Leiterplatte (10) und Kabel (11) dazwischen verbleiben, **gekennzeichnet ist es durch** eine erste Aufnahme (4), die an der Basis der ersten Abdeckung (2) angeordnet ist und die die Leiterplatte (10) aufnimmt; eine zweite Aufnahme (5), die an die erste Aufnahme (4) angrenzt und in der die von der Leiterplatte (10) ausgehenden Kabel (11) gelagert sind; eine erste Wand (6), an der die zweite Aufnahme (5) an die erste Aufnahme (4) angrenzt; eine zweite Wand (7), die gegenüber der ersten Wand (6) angeordnet ist; und und mindestens ein schlitzförmiges erstes Lager und mindestens ein schlitzförmiges zweites Lager (8 und 9) an jeder der ersten und zweiten Wände (6 und 7), wobei die ersten und zweiten Lager (8 und 9) an jeder Wand (6 und 7) ein Paar bilden, wobei jedes Paar von ersten und zweiten Lagern (8 und 9) ein Lager und den Austritt von nur einem Kabel (11) aus dem Wechselrichterplatinengehäuse (1) bereitstellt, wobei die Lager (8 und 9) sich in der vertikalen Achse erstrecken und von oben nach unten geneigt sind, so dass die Lager (8) an der ersten Wand (6) von der ersten Wand (6) zur zweiten Wand (7) geneigt sind und die Lager (9) an der zweiten Wand (7) von der zweiten Wand (7) nach außen geneigt sind.

2. Ein Wechselrichterplatinengehäuse (1), wie in Anspruch 1 aufgeführt, **ist dadurch gekennzeichnet, dass** sich mindestens ein erstes Lager (8) an der ersten Wand (6) und mindestens ein zweites Lager (9) an der zweiten Wand (7) befindet.

3. Ein Wechselrichterplatinengehäuse (1), wie in Anspruch 1 und 2 aufgeführt, **ist dadurch gekennzeichnet, dass** das erste und das zweite Lager (8 und 9), deren durch die Mitte verlaufende Achsen in der gleichen geneigten Richtung angeordnet sind.

4. Ein Wechselrichterplatinengehäuse (1), wie in Anspruch 1, 2 und 3 aufgeführt, **ist dadurch gekennzeichnet, dass** zwei erste und zweite Lager (8 und 9) parallel zueinander sind.

5. Ein Wechselrichterplatinengehäuse (1), wie in einem der vorherigen Ansprüchen aufgeführt, **ist dadurch gekennzeichnet, dass** mindestens eine Stütze (12), die sich vom Boden der zweiten Aufnahme (5) nach oben erstreckt, die die Form eines Vorsprungs hat, die sich parallel zu den ersten und zweiten Wänden (6 und 7) erstreckt, und die von unten die in den ersten und zweiten Lagern (8 und 9) verlegten Kabel (11) trägt.

6. Ein Wechselrichterplatinengehäuse (1), wie in einem der vorherigen Ansprüchen aufgeführt, **ist dadurch gekennzeichnet, dass** die zweite Aufnahme (5) an ihrer oberen kurzen Seite von oben nach unten geneigt ist.

## Revendications

1. Un boîtier de carte d'onduleur (1) **comprenant** un premier couvercle (2) et un deuxième couvercle (3) qui est monté sur le premier couvercle (2) de telle sorte qu'une carte de circuit (10) et des câbles (11) restent entre eux, **caractérisé par** un premier réceptacle (4) qui est disposé sur la base du premier couvercle (2) et qui reçoit la carte de circuit (10) ; un deuxième réceptacle (5) qui est adjacent au premier réceptacle (4) et dans lequel les câbles (11) s'étendant depuis la carte de circuit (10) sont supportés ; une première paroi (6) où le deuxième réceptacle (5) est adjacent au premier réceptacle (4) ; une deuxième paroi (7) qui est disposée à l'opposé de la première paroi (6) ; et au moins un premier palier en forme de fente et au moins un deuxième palier en forme de fente (8 et 9) sur chacune des première et deuxième parois (6 et 7) et les premier et deuxième paliers (8 et 9) sur chaque paroi (6 et 7) forment une paire où chaque paire de premier et deuxième paliers (8 et 9) fournit un palier et la sortie d'un seul câble (11) du boîtier de carte d'onduleur (1), les paliers (8 et 9) s'étendent dans l'axe vertical et sont inclinés de haut en bas de telle sorte que les paliers (8) sur la première paroi (6) sont inclinés de la première paroi (6) vers la deuxième paroi (7) et les paliers (9) sur la deuxième paroi (7) sont inclinés vers l'extérieur de la deuxième paroi (7).

2. Un boîtier de carte d'onduleur (1) tel que revendiqué dans la revendication 1, **caractérisé par** au moins un premier palier (8) sur la première paroi (6) et au moins un deuxième palier (9) sur la deuxième paroi (7).

3. Un boîtier de carte d'onduleur (1) tel que revendiqué dans les revendications 1 et 2, **caractérisé par** les premiers et deuxième paliers (8 et 9) dont les axes passant par leur centre sont situés dans la même direction inclinée.

4. Un boîtier de carte d'onduleur (1) tel que revendiqué dans les revendications 1, 2 et 3, **caractérisé par** deux premiers et deuxièmes paliers (8 et 9) qui sont parallèles entre eux.

5. Un boîtier de carte d'onduleur (1) tel que revendiqué dans l'une quelconque des revendications précédentes, **caractérisé par** au moins un support (12) qui s'étend vers le haut depuis la base du deuxième réceptacle (5), qui est sous forme d'une saillie, qui s'étend parallèlement aux première et deuxième parois (6 et 7), et qui supporte depuis le dessous les câbles (11) placés dans les premiers et deuxième paliers (8 et 9).

6. Un boîtier de carte d'onduleur (1) tel que revendiqué dans l'une quelconque des revendications précédentes, **caractérisé par** le deuxième réceptacle (5) dont le petit côté supérieur est incliné de haut en bas.
